# EUROPEAN PATENT SPECIFICATION

(11) **EP 3 968 400 B1**
(45) Date of publication and mention of the grant of the patent: **18.12.2024**
(21) Application number: 21196018.2
(22) Date of filing: 10.09.2021
(51) Int. Cl.: G11C 13/00, G11C 11/56, H10N 70/00, H10N 70/20, H10B 63/00

(54) **SYSTEM AND DEVICE INCLUDING MEMRISTOR MATERIAL**
SYSTEM UND VORRICHTUNG MIT EINEM MEMRISTOR-MATERIAL
SYSTÈME ET DISPOSITIF COMPRENANT UN MATÉRIAU DE MEMRISTANCE

(30) Priority: 10.09.2020 US 202017017313; 10.09.2020 US 202017017365; 07.12.2020 US 202017113329; 07.12.2020 US 202017113406
(43) Date of publication of application: 16.03.2022
(73) Proprietor: Rockwell Collins, Inc., Cedar Rapids, IA 52498 (US)
(72) Inventor: SNYDER, Kyle B., Marion, IA (US); WYCKOFF, Nathaniel P., Marion, IA (US); HAMILTON, Brandon C., Marion, IA (US); ROWENHORST, Bruce E., Marion, IA (US); WIEBERS, Steven J., Center Point, IA (US)
(74) Representative: Dehns

(56) References cited:
- WO-A1-2012/030320
- US-A1- 2012 176 831
- US-A1- 2013 044 525
- US-B2- 8 737 113

## Description

### CROSS-REFERENCE TO RELATED APPLICATIONS

The present application is related to: United States Application Serial Number 17/017,313, titled SYSTEM AND DEVICE INCLUDING MEMRISTOR MATERIAL, filed - September 10, 2020; United States Application Serial Number 17/017,365, titled SYSTEM AND DEVICE INCLUDING MEMRISTOR MATERIAL, filed September 10, 2020; and United States Application titled SYSTEM AND DEVICE INCLUDING MEMRISTOR MATERIAL, United States Application Serial Numbers 17/017,313 and 17/017,365.

### BACKGROUND

Memristors have been the subject of discussion and research, but have not been used in many commercial applications. WO 2012/030320 A1 describes a multilayer memory array. US 2012/176831 and US8737113 describe a resistive random access memory US2013044525 is directed to a asymmetric switching rectifier comprising memristive switching devices.

### SUMMARY

The present invention is directed to a system comprising a multi-lead memristor according to the independent device claim 1 and to a method according to the independent method claim 11.

### BRIEF DESCRIPTION OF THE DRAWINGS

Implementations of the inventive concepts disclosed herein may be better understood when consideration is given to the following detailed description thereof. Such description makes reference to the included drawings, which are not necessarily to scale, and in which some features may be exaggerated and some features may be omitted or may be represented schematically in the interest of clarity. Like reference numerals in the drawings may represent and refer to the same or similar element, feature, or function. In the drawings:
FIG. 1A is a view of an example of a memristor not forming part of the invention.
FIG. 1B is a view of an example. of the system of FIG. 1A.
FIG. 1C is a view of an example of the system of FIG. 1A
FIG. 1D is a view of an example of the system of FIG. 1A.
FIG. 2 is an example of a memristor not forming part of the invention.
FIG. 3 is an example of a memristor not forming part of the invention.
FIG. 4 is an example of a memristor not forming part of the invention.
FIG. 5 is an exemplary graph.
FIG. 6 is an exemplary graph.
FIG. 7 is an example of a memristor not forming part of the invention.
FIG. 8 is an exemplary graph.
FIG. 9 is an example of a memristor not forming part of the invention.
FIG. 10 is an exemplary graph.
FIG. 11 is an example of a memristor not forming part of the invention.
FIG. 12 is an exemplary graph.
FIG. 13 is an example of a memristor not forming part of the invention.
FIG. 14 is an example of a device not forming part of the invention.
FIG. 15 is an example of a memristor not forming part of the invention.
FIG. 16 is an example of a device not forming part of the invention.
FIG. 17 is an example not forming part of the invention.
FIG. 18 is an example of a memristor not forming part of the invention.
FIG. 19 is an exemplary graph.
FIG. 20 is a diagram of an example of a method not forming part of the invention.
FIG. 21 is a diagram of an example of a method not forming part of the invention.
FIG. 22 is a view of an exemplary embodiment of the system of FIG. 1A including multi-lead memristors according to the inventive concepts disclosed herein.
FIG. 23 is an exemplary embodiment of a multi-lead memristor of FIG. 22 according to the inventive concepts disclosed herein.
FIG. 24 is an exemplary embodiment of a multi-lead memristor of FIG. 22 according to the inventive concepts disclosed herein.
FIGS. 25A-B shows an exemplary embodiment of setting oxygen vacancies of a multi-lead memristor of FIG. 22 according to the inventive concepts disclosed herein.
FIGS. 25C-D shows an exemplary embodiment of IV curves associated with the set multi-lead memristor of FIGS. 25A-B according to the inventive concepts disclosed herein.
FIGS. 26A-B shows an exemplary embodiment of setting oxygen vacancies of a multi-lead memristor of FIG. 22 according to the inventive concepts disclosed herein.
FIGS. 26C-D shows an exemplary embodiment of setting oxygen vacancies of a multi-lead memristor of FIG. 22 according to the inventive concepts disclosed herein.
FIGS. 26E-F shows an exemplary embodiment of IV curves associated with the set multi-lead memristor of FIGS. 26A-B and FIGS. 26C-D according to the inventive concepts disclosed herein.
FIGS. 27A-B shows an exemplary embodiment of setting oxygen vacancies of a multi-lead memristor of FIG. 22 according to the inventive concepts disclosed herein.
FIGS. 27C-D shows an exemplary embodiment of IV curves associated with the set multi-lead memristor of FIGS. 27A-B according to the inventive concepts disclosed herein.
FIG. 28 is a diagram of an exemplary embodiment of a method according to the inventive concepts disclosed herein.

### DETAILED DESCRIPTION

Before explaining at least one embodiment of the inventive concepts disclosed herein in detail, it is to be understood that the inventive concepts are not limited in their application to the details of construction and the arrangement of the components or steps or methodologies set forth in the following description or illustrated in the drawings. In the following detailed description of embodiments of the instant inventive concepts, numerous specific details are set forth in order to provide a more thorough understanding of the inventive concepts. However, it will be apparent to one of ordinary skill in the art having the benefit of the instant disclosure that the inventive concepts disclosed herein may be practiced without these specific details. In other instances, well-known features may not be described in detail to avoid unnecessarily complicating the instant disclosure. The inventive concepts disclosed herein are capable of other embodiments or of being practiced or carried out in various ways. Also, it is to be understood that the phraseology and terminology employed herein is for the purpose of description and should not be regarded as limiting.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only, and should not be construed to limit the inventive concepts disclosed herein in any way unless expressly stated to the contrary.

Further, unless expressly stated to the contrary, "or" refers to an inclusive or and not to an exclusive or. For example, a condition A or B is satisfied by anyone of the following: A is true (or present) and B is false (or not present), A is false (or not present) and B is true (or present), and both A and B are true (or present).

In addition, use of the "a" or "an" are employed to describe elements and components of embodiments of the instant inventive concepts. This is done merely for convenience and to give a general sense of the inventive concepts, and "a" and "an" are intended to include one or at least one and the singular also includes the plural unless it is obvious that it is meant otherwise.

Finally, as used herein any reference to "one embodiment," or "some embodiments" means that a particular element, feature, structure, or characteristic described in connection with the embodiment is included in at least one embodiment of the inventive concepts disclosed herein. The appearances of the phrase "in some embodiments" in various places in the specification are not necessarily all referring to the same embodiment, and embodiments of the inventive concepts disclosed may include one or more of the features expressly described or inherently present herein, or any combination of sub-combination of two or more such features, along with any other features which may not necessarily be expressly described or inherently present in the instant disclosure.

In some embodiments, for a memristor element, a desired signal response can be achieved by using (e.g., modifying) at least one particular material (e.g., at least one memristor material) as a transmission medium. In some embodiments, the signal response of the memristor can be modified by controlling an oxygen vacancy transmission rate of the at least one particular material. For example, controlling the oxygen vacancy transmission rate of the at least one particular material can be achieved by a physical modification and/or a chemical modification. In some embodiments, the signal response can provide an asymmetric time based response (e.g., a homogenous asymmetric time based response and/or a compartmentalized asymmetric time based response).

Some embodiments may allow memristor characteristics to be tuned (e.g., tuned in real time during operation) to meet system design needs. Some embodiments may allow memristor elements to be tuned (e.g., additively tuned) around application specific integrated circuit (ASIC) circuitry, sometimes referred to as trimming. Some embodiments may provide circuit modification (e.g., additive circuit modification) of a memristor to improve ASIC shortcomings. Some embodiments may include tuning (e.g., additively tuning) memristor components to address timing specific needs of signal lines (e.g., key signal lines). For example, some embodiments may allow for custom signal optimization to account for a build process of circuit variance.

Some embodiments may include physically changing an order and configuration of memristor structures to develop features with unique electrical responses. For example, by controlling a geometry of a medium that is passing a signal, a movement and effect of oxygen vacancies can be controlled so as to modify a response temporarily or permanently. Such responses can inhibit an asymmetric response, a permanent penalty associated with drive direction, a time based response modification, and/or a combination thereof.

Some embodiments may allow for a potential to provide an element of repeatable uniqueness for use in anti-counterfeiting of electronic devices. Some embodiments may facilitate a generation of behavior based response techniques. Some embodiments may be useful for applications that need unique but repeatable responses (e.g., a unique fingerprint). Some embodiments may provide authenticity validation through unique but repeatable electrical responses.

Some embodiments may include at least one filter (e.g., a high pass filter and/or a low pass filter), which may include at least one memristor instead of a capacitor.

Some embodiments may include at least one multi-lead memristor.

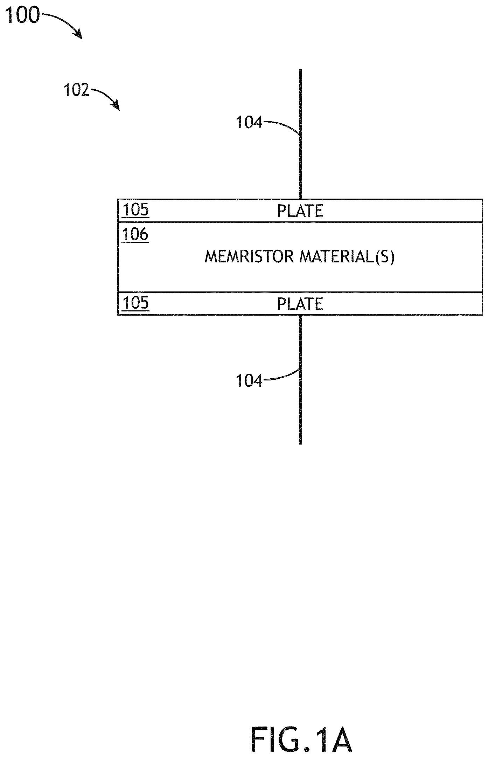

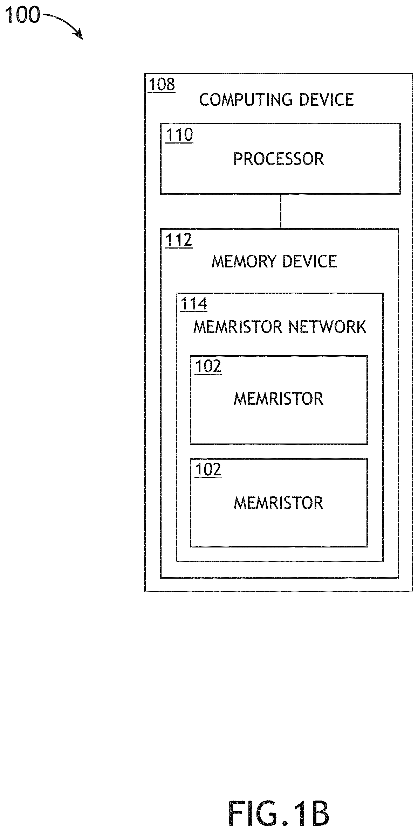

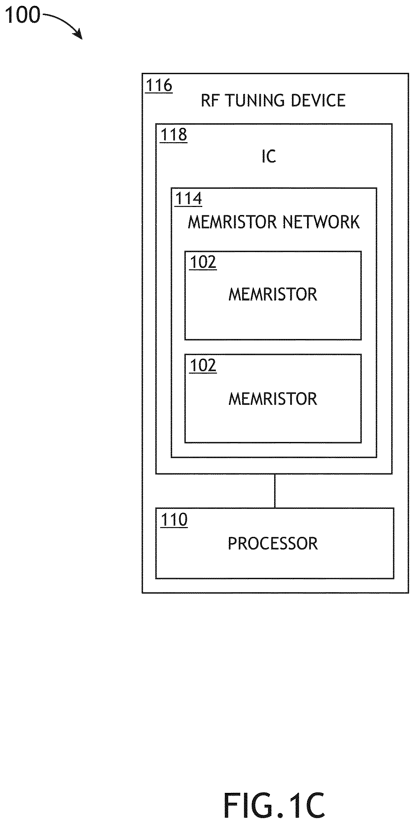

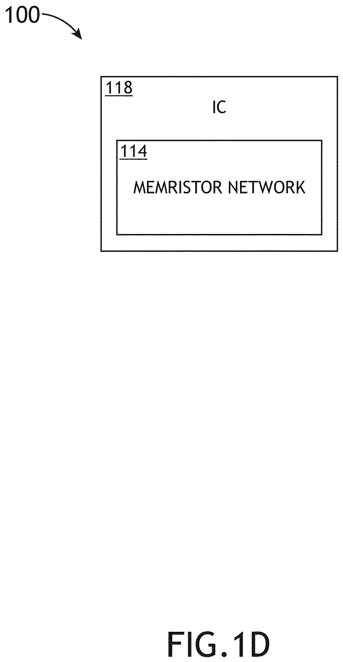

Referring now to FIGS. 1A, 1B, 1C, and 1D, examples of a system 100 according to the inventive concepts disclosed herein are depicted. The system 100 may be implemented as any suitable system, such as at least one vehicle system (e.g., at least one aircraft, at least one watercraft, at least one submersible craft, at least one automobile, and/or at least one train), a communication system, an optical system, a computing device system, a multiple computing device system, a radiofrequency (RF) device system, and/or a multiple RF device system.

For example, as shown in FIG. 1A, the system 100 may include at least one device (e.g., at least one memristor 102) including at least two terminals 104, at least two conductive plates 105, and/or at least one memristor material 106. Some or all of the at least one memristor 102 and/or any other components of the system 100 may be communicatively coupled at any given time. Some examples may include multiple memristors 102 implemented as a memristor network 114 (as shown in FIGS. 1B-1D). For example, the memristor network 114 may include a plurality of at least partially communicatively coupled (e.g., at least partially interconnected) memristors 102 that may be arranged in an array, in parallel, and/or in series. In some embodiments, the at least one memristor 102 may be fabricated on an integrated circuit (IC) device (e.g., IC 118, as shown in FIGS. 1C-1D). The at least one memristor 102 may be part of a memory device (e.g., 112, as shown in FIG. 1B).

For example, a first conductive plate 105 may be configured at least to receive an input signal via a first terminal 104; and a second conductive plate 105 may be configured at least to output an output signal via a second terminal 104. For example, the at least one memristor material 106 may be positioned between the first conductive plate 105 and the second conductive plate 105.

The at least one memristor material 106 may be composed of any suitable memristor material, such as any suitable ionic-covalent metal compound. For example, each of the at least one memristor material 106 may comprise at least one of: at least one metal oxide (e.g., TiO₂, ZrO₂, NiO, CuO, CoO, Fe₂O₃, MoO, VO₂, and/or HfO₂), at least one metal sulfide, at least one metal selenide, at least one metal telluride, at least one metal nitride, at least one metal phosphite, and/or at least one metal arsenide. TiO₂, ZrO₂, NiO, CuO, CoO, Fe₂O₃, MoO, VO₂, and HfO₂ are known in the art to be suitable memristor materials. Each memristor material 106 has oxygen vacancy and/or anion vacancy characteristics. Oxygen vacancy refers to a point defect in a crystal or glass where an oxygen ion is missing at an expected lattice or structure position, which results in a net positive charge, a trapped electron, and a metastable atomic structure. Anion vacancy refers to a point defect in a crystal or glass where an anion ion is missing at an expected lattice or structure position, which results in a net positive charge, a trapped electron, and a metastable atomic structure.

For example, as shown in FIG. 1B, the system 100 may include at least one computing device 108. If the system 100 includes multiple computing devices 108, some or all of the computing devices 108 may be communicatively coupled at any given time.

The computing device 108 may include at least one processor 110 and/or at least one memory device 112, some or all of which may be communicatively coupled at any given time. Each of the processor 110 and/or the memory device 112 may include at least one circuit (e.g., at least one IC 118, as shown in FIGS. 1C-1D).

The at least one processor 110 may be implemented as any suitable type and number of processors. For example, the at least one processor 110 may include at least one general purpose processor (e.g., at least one central processing unit (CPU)), at least one digital signal processor (DSP), at least one application specific integrated circuit (ASIC), at least one field-programmable gate array (FPGA), at least one complex programmable logic device (CPLD), and/or at least one graphics processing unit (GPU). The at least one processor 110 may be configured to perform (e.g., collectively perform if more than one processor) any or all of the operations disclosed throughout. The processor 110 may be configured to run various software and/or firmware applications and/or computer code stored (e.g., maintained) in a non-transitory computer-readable medium (e.g., memory device 112) and configured to execute various instructions or operations. For example, the at least one processor 110 may be configured to: output a signal; receive a signal; output data to the memory device 112; receive data from the memory device 112; determine and/or use a signature of a received signal; perform anti-piracy operations based at least on the signature; perform cyber security authentication operations based at least on the signature; perform unique data storage operations based at least on the signature; perform usage temperature authentication operations based at least on the signature; cause a barrier material to be fused; and/or cause an activation of at least one of a blocking material, a permanent modification material, or a transfer rate modification material.

The memory device 112 may include the at least one memristor 102, which may be implemented as the memristor network 114 if more than one memristor 102. For example, the memory device 112 may be a non-volatile and/or persistent memory device. For example, the memory device 112 may be configured to: store data; read data; write data; output data; receive data; receive input signals; output signals; determine and/or use a signature of a received signal; perform anti-piracy operations based at least on the signature; perform cyber security authentication operations based at least on the signature; perform unique data storage operations based at least on the signature; perform usage temperature authentication operations based at least on the signature; cause a barrier material to be fused; and/or cause an activation of at least one of a blocking material, a permanent modification material, or a transfer rate modification material

For example, as shown in FIG. 1C, the system 100 may include at least one RF tuning device 116. If the system 100 includes multiple RF tuning devices 116, some or all of the RF tuning devices 116 may be communicatively coupled at any given time.

The RF tuning device 116 may include at least one processor 110, at least one IC 118, and/or at least one memory device 112, some or all of which may be communicatively coupled at any given time. Each of the processor 110, the IC 118, and/or the memory device 112 may include at least one circuit (e.g., at least one IC 118, as shown in FIGS. 1C-1D). The RF tuning device 116 may be configured to tune RF signal outputs.

The at least one processor 110 may be implemented similarly and function similarly to the processor 110 shown in FIG 1B, except that the at least one processor 110 may be further configured to cause RF tuning operations to be performed.

The IC 118 may include the at least one memristor 102, which may be implemented as the memristor network 114 if more than one memristor 102. The at least one IC 118 may be configured to perform (e.g., collectively perform if more than one IC) any or all of the operations disclosed throughout. The IC 118 may be configured to run various software and/or firmware applications and/or computer code stored (e.g., maintained) in a non-transitory computer-readable medium (e.g., memory device 112) and configured to execute various instructions or operations. For example, the IC 118 may be configured to: output a signal; receive a signal; output data to the memory device 112; receive data from the memory device 112; determine and/or use a signature of a received signal; perform anti-piracy operations based at least on the signature; perform cyber security authentication operations based at least on the signature; perform unique data storage operations based at least on the signature; perform usage temperature authentication operations based at least on the signature; cause a barrier material to be fused; cause an activation of at least one of a blocking material, a permanent modification material, or a transfer rate modification material; and/or perform RF signal tuning operations.

For example, as shown in FIG. 1D, the system 100 may include at least one circuit (e.g., at least one IC 118). If the system 100 includes multiple ICs 118, some or all of the ICs 118 may be communicatively coupled at any given time. The at least one IC 118 may be implemented similarly and function similarly to the IC 118 shown in and described with respect to FIG. 1C.

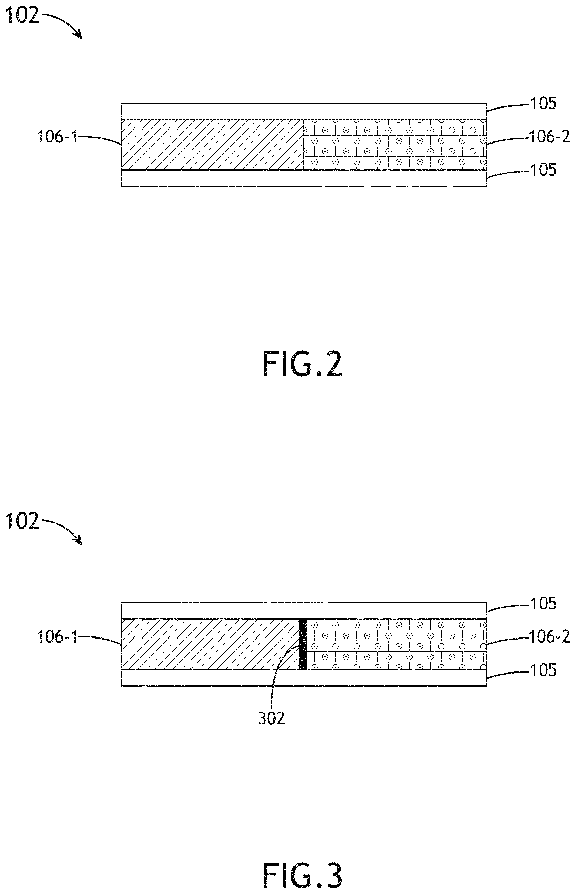

Referring now to FIGS. 2-6, examples not forming part of the invention of the system 100 including at least one memristor 102 are depicted

Referring now to FIG. 2, an example of at least one memristor 102 is depicted.

For example, the memristor 102 may include a first conductive plate 105 configured at least to receive an input signal, a second conductive plate 105 configured at least to output an output signal, and at least two memristor materials (e.g., a first memristor material 106-1 and a second memristor material 106-2). The first memristor material 106-1 may be positioned between the first conductive plate 105 and the second conductive plate 105. The second memristor material 106-2 may be positioned between the first conductive plate 105 and the second conductive plate 105. The first memristor material 106-1 and the second memristor material 106-2 may be in parallel electrically. The first memristor material 106-1 may be different from the second memristor material 106-2. For example, the first memristor material 106-1 may be a relatively slower or faster response material than the second memristor material 106-2. Memristor response may depend on the crystal chemistry, crystal phase, the amount of underproportination and disproportionation, etc. Memristor response may be influenced by the cation-anion bond strength and the cation-anion size ratio. The responsiveness of the memristor materials 106 can be measured. The responsiveness of the memristor materials 106 can be approximated by Gibbs Free Energy of Formation since Gibbs Free Energy of Formation incorporates several energy well/barrier type quantities. Based on approximated responsiveness using Gibbs Free Energy of Formation, some examples of memristor materials 106 ordered from relatively slower approximated responsiveness to relatively faster approximated responsiveness are: Ti₂O₃ at - 11,133,903 ΔGf° (kJ/mol); Ta₂O₅ at -1,910,984 ΔGf° (kJ/mol); Sc₂O₃ at -1,819,371 ΔGf° (kJ/mol); Nb₂O₅ at -1,765,859 ΔGf° (kJ/mol); TiO₂ (Rutile) at -889,446 ΔGf° (kJ/mol); TiO₂ (Anatase) at -883,303 ΔGf° (kJ/mol); NbO₂ at -739,194 ΔGf° (kJ/mol); MgO at -569,196 ΔGf° (kJ/mol); and NbO at -391,945 ΔGf° (kJ/mol).

The first memristor 106-1 material has a first current-voltage (I-V) curve, the second memristor material 106-2 has a second I-V curve, and the memristor 102 has a third I-V curve, wherein each of the first, second, and third I-V curves are different. For example, as shown in FIG. 2, the third I-V curve is indicative of an asymmetric time-based response (e.g., a homogenous asymmetric time-based response). The output signal of the memristor 102 may have a signature based at least on the asymmetric time-based response. For example, the signature may be at least semi-unique (e.g., unique, unique to a product, or unique to a manufacturer) and/or may be indicative of at least one of an identity or an authenticity of an electronic component or device. A circuit (e.g., an IC 118) may be configured to receive and use the signature of the output signal for at least one of: anti-piracy, cyber security authentication, unique data storage, electronic serialization, or usage temperature authentication (e.g., by fusing the barrier material 302). For example, the signature can be achieved by strategically selection of the at least two memristor materials (e.g., 106-1, 106-2), dimensions of the at least two memristor materials (e.g., 106-1, 106-2), and/or an arrangement of the at least two memristor materials (e.g., 106-1, 106-2). For example, the signature may be used as an identification feature for part authentication.

Referring now to FIG. 3, an example of at least one memristor 102 is depicted.

For example, the memristor 102 may be implemented similarly and function similarly to the memristor of FIG. 2, except that the memristor 102 of FIG. 3 may include at least one barrier material 302.

For example, the barrier material 302 may extend from the first conductive plate 105 to the second conductive plate 105. The barrier material 302 may be positioned between the first memristor material 106-1 and the second memristor material 106-2 such that the first memristor material 106-1 is not in contact with the second memristor material 106-2. The barrier material 302 may be a fuse configured to permanently configure the memristor 102, for example, that may be activated thermally. For example, some examples of suitable barrier materials may include any noble metal (e.g., Au, Pt, Ag, Ir, Rh, Ru, Pd, and/or Os), highly covalently bonded material (e.g., carbon allotropes, silicon allotropes, Ge, Te, and/or Se, etc...), mostly elemental forms of nonmetals and metalloids which form solids at standard temperature and pressure (STP) for periodic table groups 14, 15, and 16, or some combination thereof.

The first memristor 106-1 material has a first current-voltage (I-V) curve, the second memristor material 106-2 has a second I-V curve, and the memristor 102 has a third I-V curve, wherein each of the first, second, and third I-V curves are different. For example, as shown in FIG. 2, the third I-V curve is indicative of an asymmetric time-based response (e.g., a compartmentalized asymmetric time-based response). The output signal of the memristor 102 may have a signature based at least on the asymmetric time-based response. For example, the signature may be at least semi-unique (e.g., unique, unique to a product, or unique to a manufacturer) and/or may be indicative of at least one of an identity or an authenticity of an electronic component or device. A circuit (e.g., an IC 118) may be configured to receive and use the signature of the output signal for at least one of: anti-piracy, cyber security authentication, unique data storage, electronic serialization, or usage temperature authentication (e.g., by fusing the barrier material 302). For example, the signature can be achieved by strategic selection of the at least two memristor materials (e.g., 106-1, 106-2), dimensions of the at least two memristor materials (e.g., 106-1, 106-2), and/or an arrangement of the at least two memristor materials (e.g., 106-1, 106-2). For example, the signature may be used as an identification feature for part authentication.

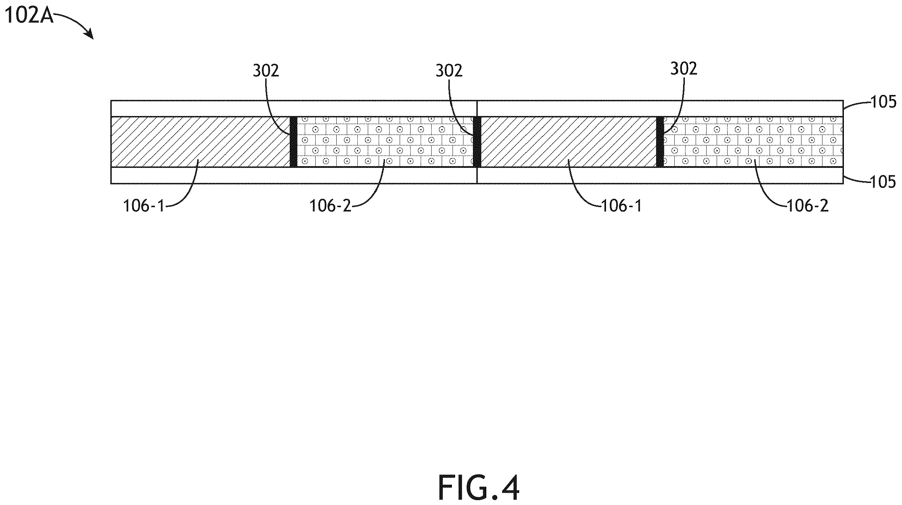

Referring now to FIG. 4, an example of at least one memristor 102 is depicted.

For example, the memristor 102 may be implemented similarly and function similarly to the memristor of FIG. 2 and/or 3, except that the memristor 102 of FIG. 4 may include at least two of the first memristor material 106-1, at least two of the second memristor material 106-2, and at least two barrier material 302. For example, the first memristor material 106-1 sections, the second memristor material 106-2 sections, and barrier material 302 sections may be interspersed (e.g., in one dimension or two dimensions (e.g., in a two-dimensional array)). In some embodiments, one or more of the barrier material 302 sections may be omitted. The memristor 102 may include more than one (e.g., two, three, four, or more) type of memristor material 106.

Referring to FIGS. 3-4, the barrier material 302 may be used to permanently change the memristor 102. For example, the barrier material 302 may be used to permanently change a phase of the memristor 102.

For example, the barrier material 302 may be used to permanently configure the memristor 102, for example, to set the memristor 102 to a known value. For example, the barrier material 302 may be activated thermally and act as a fusing structure. Different materials for the memristor materials 106-1, 106-2 and/or the barrier material(s) 302 may be used to control a speed of and an amount of oxygen depletion transfer.

Memristors 102 may be arranged in an array as a memristor network 114. For example, the memristor network 114 (e.g., which may be implemented in the RF tuning device 116) may be used for configuring test values (e.g., resistance values). For example, the memristor network 114 may be used to tune a circuit (e.g., an IC 118, such as an ASIC) by trimming resistance values (e.g., by using test selects). For example, the memristor network 114 may be used to tune a resistor-capacitor (RC) circuit delay. For example, such tuning may be similar to how mixed signals circuits are tuned by swapping resistors after a characterization test is complete, then retesting for proper performance. The memristor network 114 may be configured as multiple interconnected memristors 102 or as a single memristor 102 having multiple fuseable barrier materials 302. One memristor 102 of the memristor network 114 may influence another memristor 102 of the memristor network 114, for example, based on a fusing of a barrier material 302.

At least one memristor 102 having at least one barrier material 302 may be used in the memory device 112 (e.g., a non-volatile memory device).

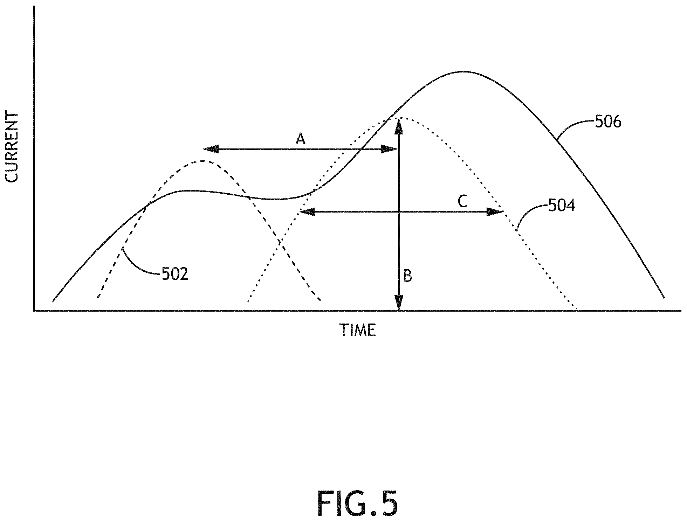

Referring now to FIG. 5, an exemplary graph of current versus time is shown. The graph shows a first curve 502, a second curve 504, and a third curve 506. The first curve 502 demonstrates a responsiveness of the first memristor material 106-1. The second curve 504 demonstrates a responsiveness of the second memristor material 106-2. The third curve 506 demonstrates a responsiveness of the memristor 102 having the first memristor material 106-1 and the second memristor material 106-2. The third curve 506 may be indicative of an asymmetric time-based response (e.g., a homogenous asymmetric time-based response and/or a compartmentalized asymmetric time-based response) that may be associated with a signature as discussed herein.

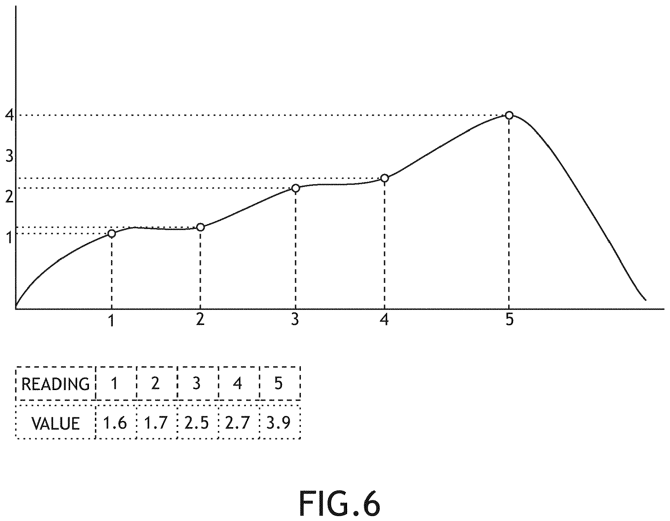

Referring now to FIG. 6, an exemplary graph of current versus time for a memristor 102 is shown. For example, values of the output current for the memristor 102 can be read at various times (e.g., 5 times, as shown). The combination of the values read at different times can be used as a signature as discussed herein.

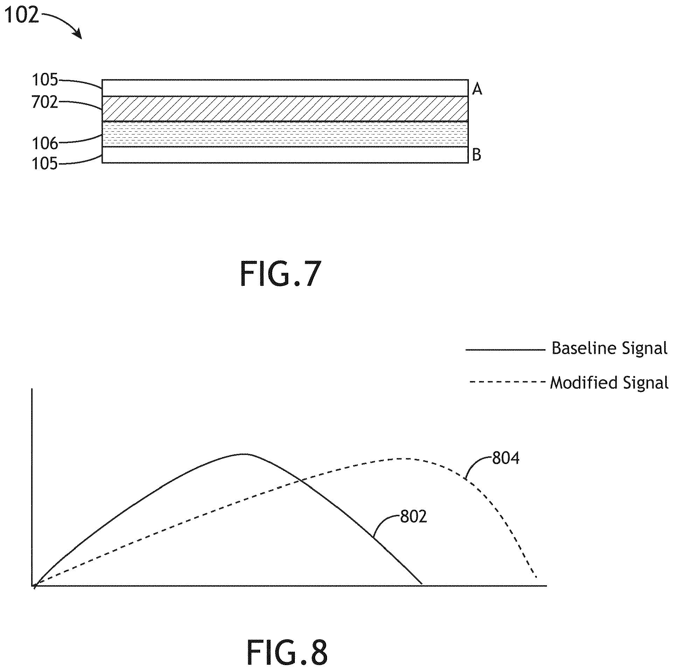

Referring now to FIGS. 7-19, examples not forming part of the invention of the system 100 including at least one memristor 102 are depicted Each memristor 102 may include at least one blocking material 602, at least one permanent modification material 902, and/or at least one transfer rate modification material 702.

A blocking material 602 may be any suitable material that does not permit transmission of a memristor charge carrying mechanism. Some examples of suitable blocking materials 602 include gold (Au), platinum (Pt), and/or palladium (Pd).

A permanent modification material 902 may be any suitable material that absorbs memristor charge carriers. An example may be a cation oxidation number change that results in absorption or generation of total oxygen vacancies. Some examples of suitable permanent modification materials 902 may include a metal oxide (e.g., a metal oxide near the surface of the electrode whose cation is reduced to its metallic form and whose anion fills the oxygen vacancy), such as a noble metal oxide.

A transfer rate modification material 702 may be any suitable material that changes a transmission rate of memristor charge carriers. An example may be a transient or residual crystallographic phase change which results in a change in oxygen vacancy transmission rate. For example, a transfer rate modification material 702 may be implemented by depositing a material in a metastable crystal phase or glassy phase (which may be inherently metastable) such that a thermal or optical stimulus initiates a phase shift to the more stable phase at the usage temperature. Depositing in a metastable phase can be accomplished by modifying the deposition rate, substrate biasing, and/or deposition pressure. Since the oxygen vacancy conduction rate is dependent on the crystal phase, the memristor response will be different after the phase transformation. For such an example, TiO2 in Rutile and Anatase may have a different memristor response since the bond strength is different and the crystal geometry is different. Additionally, for example, a transfer rate modification material 702 may be implemented by depositing a material that has a crystal phase transition over the operation temperature. The memristor response would change discontinuously at the temperature where the crystal phase changes. For example, VO₂ has a monoclinic to tetragonal crystal phase transition around 67 degrees Celsius and may be a suitable transfer rate modification material 702.

Referring now to FIG. 7, an example of at least one memristor 102 is depicted. The memristor 102 may be implemented similarly and function similarly to the memristor 102 of FIG. 1A, except that the memristor 102 of FIG. 7 may include at least one transfer rate modification material 702.

The transfer rate modification material 702 may be positioned between the first conductive plate 105 and the second conductive plate 105. At least a portion of the transfer rate modification material 702 may abut the memristor material 106. The transfer rate modification material 702 may provide a shift in a stabilization time to the output signal after a signal is driven from the second conductive plate 105 (B) to the first conductive plate 105 (A).

Referring now to FIG. 8, an exemplary graph of current versus time is shown. The graph shows a first curve 802 and a second curve 804. The first curve 802 is associated with a baseline signal (e.g., an unmodified signal) before activation of the transfer rate modification material 702. The second curve 804 is associated with a modified signal after activation of the transfer rate modification material 702. For example, this modification may result in a modified output signal from the first conductive plate 105 (A) to the second conductive plate 105 (B).

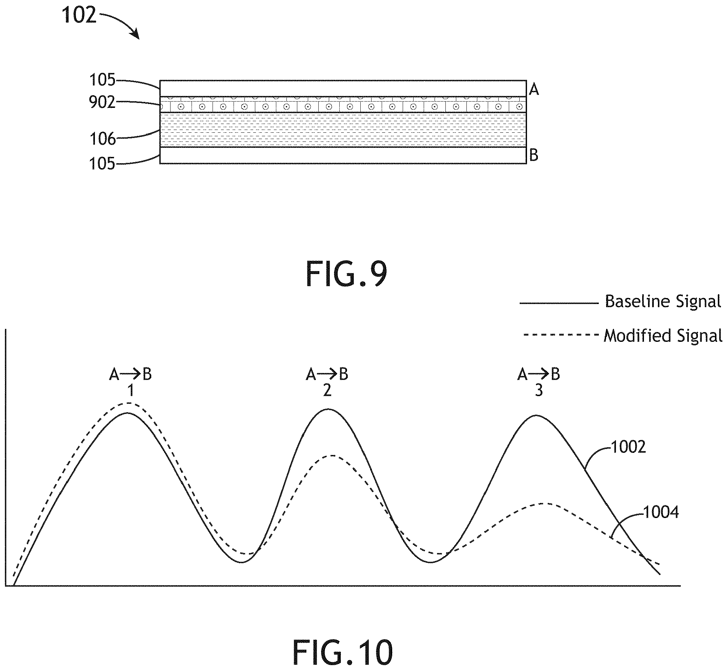

Referring now to FIG. 9, an example of at least one memristor 102 is depicted. The memristor 102 may be implemented similarly and function similarly to the memristor 102 of FIG. 1A, except that the memristor 102 of FIG. 9 may include at least one permanent modification material 902.

The permanent modification material 902 may be positioned between the first conductive plate 105 and the second conductive plate 105. At least a portion of the permanent modification material 902 may abut the memristor material 106. The permanent modification material 902 may provide a permanent signal modification (e.g., a permanent uniform signal modification) to the output signal after a signal is driven from the second conductive plate 105 (B) to the first conductive plate 105 (A). For example, this modification may result in a modified output signal from the first conductive plate 105 (A) to the second conductive plate 105 (B). Each subsequent activation (e.g., by driving a signal from the second conductive plate 105 (B) to the first conductive plate 105 (A)) of the permanent modification material 902 may compound modification effects.

Referring now to FIG. 10, an exemplary graph of current versus time is shown. The graph shows a first curve 1002 and a second curve 1004. The first curve 1002 is associated with a baseline signal (e.g., an unmodified signal) before activation of the permanent modification material 902. The second curve 1004 is associated with a modified signal after activation of the permanent modification material 902.

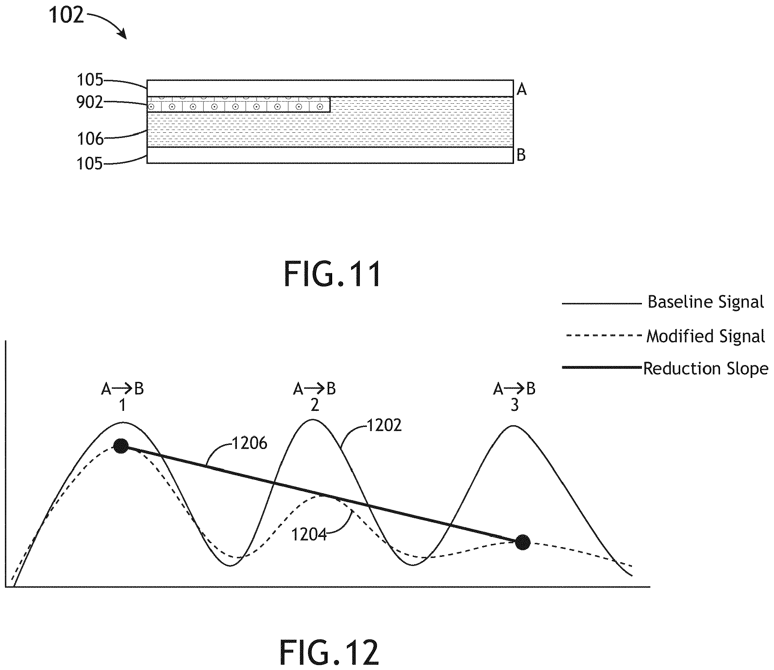

Referring now to FIG. 11, an example of at least one memristor 102 is depicted. The memristor 102 may be implemented similarly and function similarly to the memristor 102 of FIG. 9, except that the at least one permanent modification material 902 does not fully extend along the first plate 105 (A). For example, the memristor material 106 may abut a first surface area of the first conductive plate 105 (A). The memristor material 106 may abut a second surface area of the second conductive plate 105 (B). The first surface area and the second surface area may be different. The permanent signal modification may be a permanent asymmetric signal modification.

Referring now to FIG. 12, an exemplary graph of current versus time is shown. The graph shows a first curve 1202, a second curve 1204, and a reduction slope 1206. The first curve 1202 is associated with a baseline signal (e.g., an unmodified signal) before activation of the permanent modification material 902. The second curve 1204 is associated with a modified signal after activation of the permanent modification material 902.

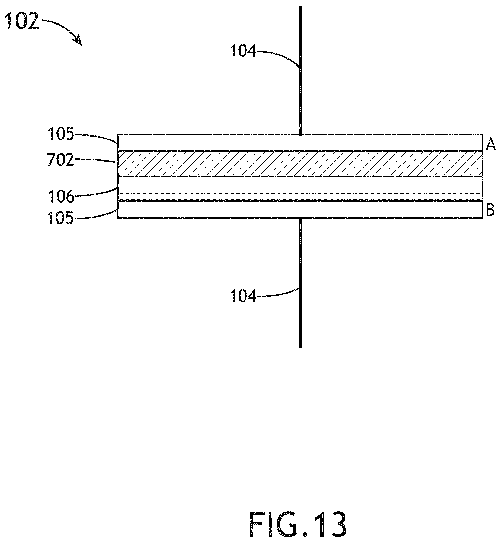

Referring now to FIG. 13, an example of at least one memristor 102 according to the inventive concepts disclosed herein is depicted. The memristor 102 may be implemented similarly and function similarly to the memristor of FIG. 7, except that the memristor 102 may be a notch filter.

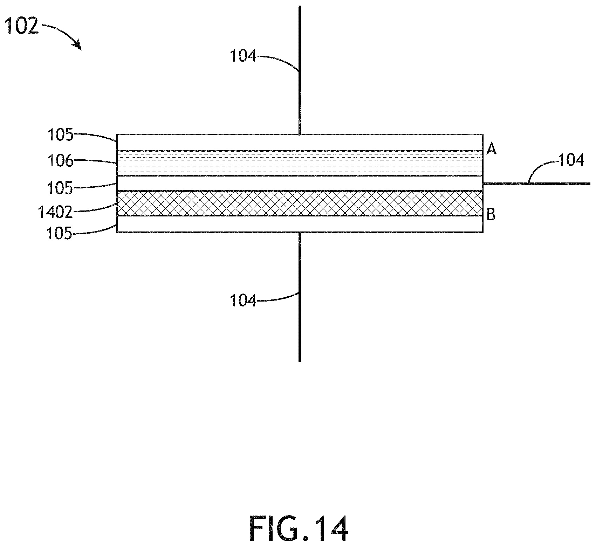

Referring now to FIG. 14, an example of at least one device 102A is depicted. The device 102A may be implemented similarly and function similarly to the memristor 102 of FIG. 7, except that the device 102A may further include at least one dielectric material 1402, a third conductive plate 105, and a third terminal 104.

The device 102A may include the first conductive plate 105, the second conductive plate 105, the memristor material 106, a third conductive plate 105, a dielectric material 1402, a first terminal 104 electrically coupled to the first conductive plate 105, a second terminal 104 electrically coupled to the second conductive plate 105, and a third terminal 104 electrically coupled to the third conductive plate 105. The dielectric material 1402 may be positioned between the second conductive plate 105 and the third conductive plate 105. The device 102A may have memristor functionality and capacitor functionality. The device 102 may be a bandpass filter, which for example, may be combined RC time constant.

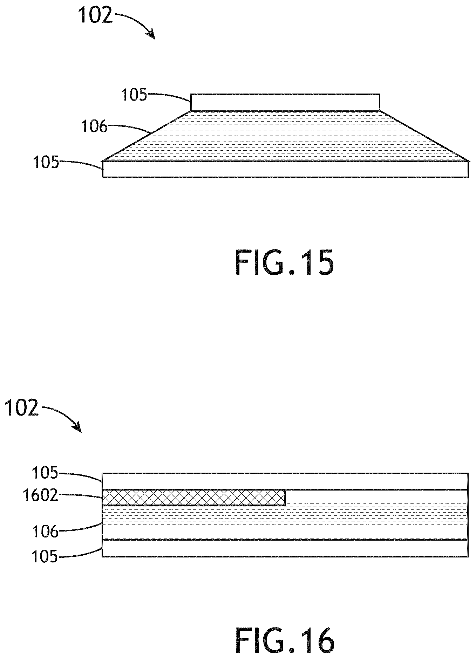

Referring now to FIGS. 15-16, examples not forming part of the invention of at least one memristor 102 are depicted. The memristor 102 may be implemented similarly and function similarly to the memristor of FIG. 1A, except that in FIGS. 15-16: the memristor material 106 may abut a first surface area of the first conductive plate 105 (A); the memristor material 106 may abut a second surface area of the second conductive plate 105 (B); and the first surface area and the second surface area may be different (e.g., the first surface area may be less the second surface area as shown in FIGS. 15-16). The memristor of FIGS. 15-16 may provide an asymmetric signal response. For example, the response can be modified to create greater oxygen vacancy density on the first conductive plate 105 (A) and lower density on the second conductive plate 105 (B). For example, such asymmetric application can be tailored by modification of a location and an amount of surface area covered by the blocking material 1602 (as shown in FIG. 16).

The asymmetric response of the memristor 102 of FIGS. 15-16 can be used for: phase shifting an input signal (e.g., a digital clock phase shift); filtering by using only resistive elements; control system feedback; integrated analog compensation for undesired hysteresis effects (e.g., a lag in a temperature sensor reading versus actual instantaneous temperature) that can reduce or eliminate a need to compensate for such effects through software.

As shown in FIG. 15, opposing faces of the first and second conductive plates 105 may have different surface areas.

As shown in FIG. 16, the memristor 102 may further include a blocking material 1602. The blocking material 1602 may be positioned between the first conductive plate 105 and the second conductive plate 105. The blocking material 1602 may abut the memristor material 106 and one of the first conductive plate 105 or the second conductive plate 105.

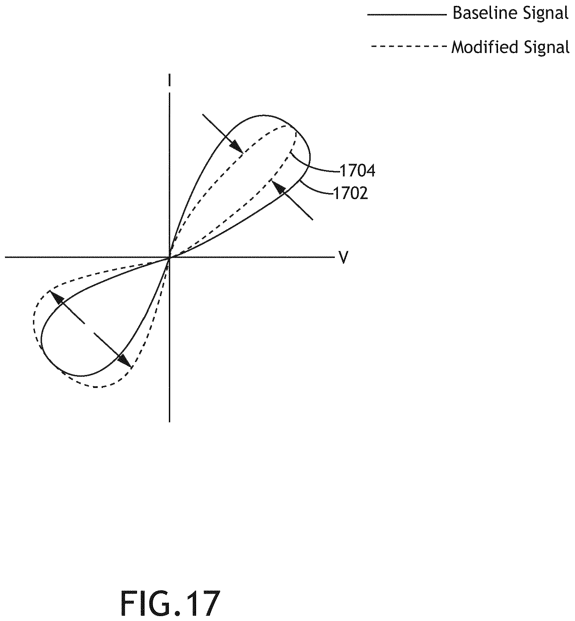

Referring now to FIG. 17, an exemplary graph of current (I) versus voltage (V) is shown. The graph shows a first I-V curve 1702 and a second I-V curve 1704. The first I-V curve 1702 is associated with a baseline signal (e.g., an unmodified signal) of a hypothetical memristor 102 with a first surface area of the first conductive plate 105 equal to the second surface area of the second conductive plate 105. The second I-V curve 1704 may be an I-V curve for the output signal of the memristor 102 of FIGS. 15-16.

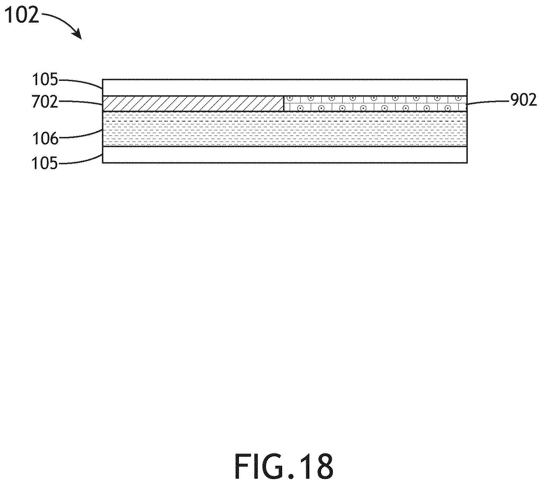

Referring now to FIG. 18, at least one memristor 102 is depicted. The memristor 102 may be implemented similarly and function similarly to the memristor of FIG. 11, except that in FIG. 18: the memristor 102 includes a permanent modification material 902 and a transfer rate modification material 702; the permanent modification material 902 may be positioned between the first conductive plate 105 (A) and the second conductive plate 105 (B); the transfer rate modification material 702 may be positioned between the first conductive plate 105 (A) and the second conductive plate 105 (B); the permanent modification material 902 and the transfer rate modification material 702 may be in parallel electrically; at least a portion of the permanent modification material 902 may abut the memristor material 106; at least a portion of the transfer rate modification material 702 may abut the memristor material 106; a combination of the permanent modification material 902 and the transfer modification material 702 may provide a modification to the output signal after a signal is driven from the second conductive plate 105 (B) to the first conductive plate 105 (A).

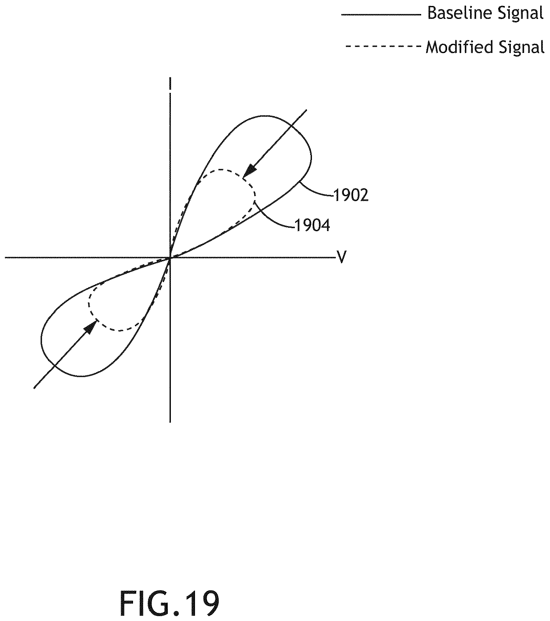

Referring now to FIG. 19, an exemplary graph of current (I) versus voltage (V) is shown. The graph shows a first I-V curve 1902 and a second I-V curve 1904. The first I-V curve 1902 is associated with a baseline signal (e.g., an unmodified signal) of a memristor 102 as shown in FIG. 1A. The second I-V curve 1904 may be an I-V curve for the output signal of the memristor 102 of FIG. 18.

The system 100 may include a memristor network 114 having any combination of type and/or number of at least two memristors 102, such as shown in FIGS. 1A, 2, 3, 4, 7, 9, 11, 13, 14, 15, 16, and/or 18.

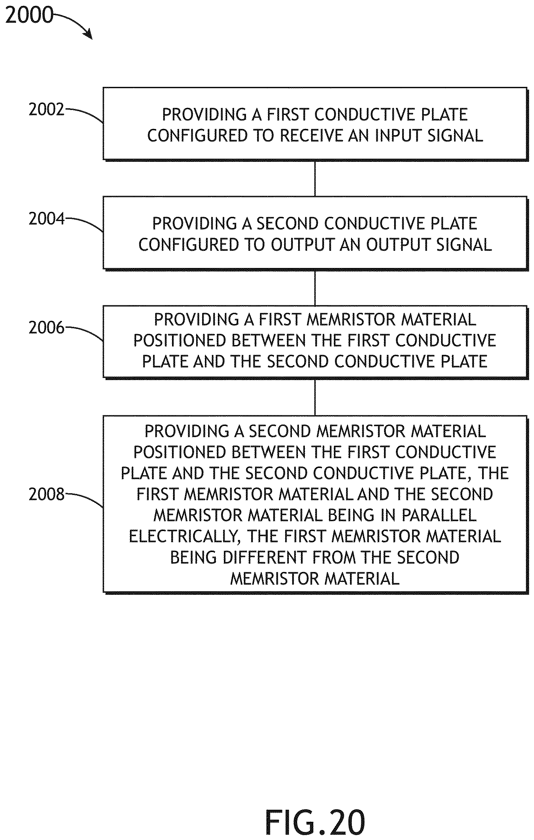

Referring now to FIG. 20, an example of a method 2000 may include one or more of the following steps. Additionally, for example, some examples may include performing one more instances of the method 2000 iteratively, concurrently, and/or sequentially. Additionally, for example, at least some of the steps of the method 2000 may be performed in parallel and/or concurrently. Additionally, At least some of the steps of the method 2000 may be performed non-sequentially. Additionally, at least some of the steps of the method 2000 may be performed in sub-steps of providing various components. The method 2000 may be performed by a semiconductor fab tool(s).

A step 2002 may include providing a first conductive plate configured to receive an input signal.

A step 2004 may include providing a second conductive plate configured to output an output signal.

A step 2006 may include providing a first memristor material positioned between the first conductive plate and the second conductive plate.

A step 2008 may include providing a second memristor material positioned between the first conductive plate and the second conductive plate, the first memristor material and the second memristor material being in parallel electrically, the first memristor material being different from the second memristor material.

Further, the method 2000 may include any of the operations disclosed throughout.

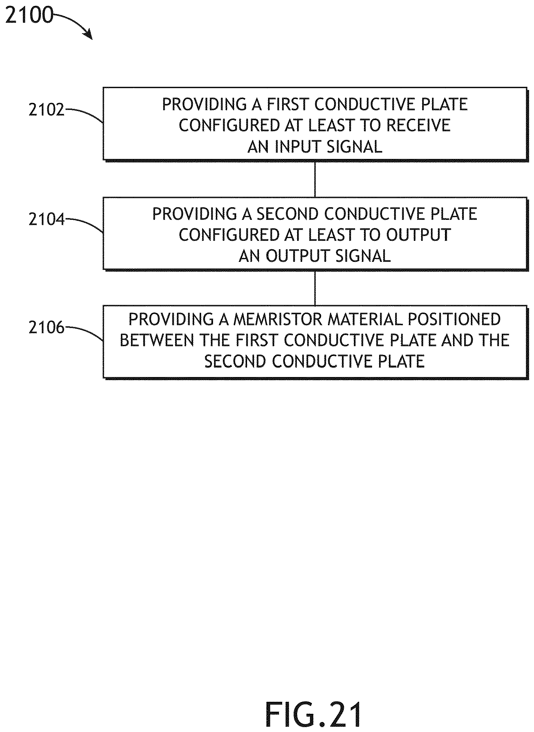

Referring now to FIG. 21, an example of a method 2100 not forming part of the invention may include one or more of the following steps. Additionally, for example, some examples may include performing one more instances of the method 2100 iteratively, concurrently, and/or sequentially. Additionally, for example, at least some of the steps of the method 2100 may be performed in parallel and/or concurrently. Additionally, in some examples, at least some of the steps of the method 2100 may be performed non-sequentially. Additionally, in some examples, at least some of the steps of the method 2100 may be performed in sub-steps of providing various components. The method 2100 may be performed by a semiconductor fab tool(s).

A step 2102 may include providing a first conductive plate configured at least to receive an input signal.

A step 2104 may include providing a second conductive plate configured at least to output an output signal.

A step 2106 may include providing a memristor material positioned between the first conductive plate and the second conductive plate.

Further, the method 2100 may include any of the operations disclosed throughout.

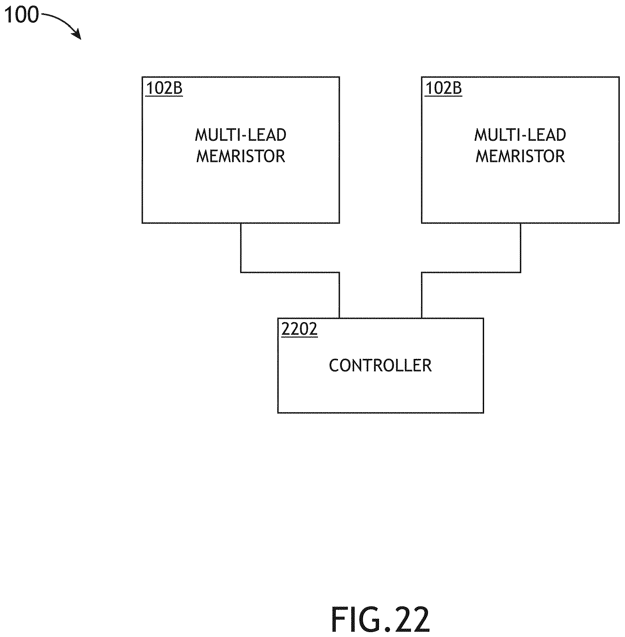

Referring now to FIGS. 22-28, further exemplary embodiments of the system 100 according to the inventive concepts disclosed herein are depicted. For example, the at least one memristor 102 may be at least one multi-lead memristor 102B. The multi-lead memristor 102B may include any or all of the elements and/or any or all of the arrangement of the elements described with respect to the memristor 102, as disclosed throughout.

Referring now to FIG. 22, an exemplary embodiment of the system 100 according to the inventive concepts disclosed herein is depicted. The system 100 may include at least one (e.g., two (as shown) or more) multi-lead memristor 102B communicatively coupled to at least one controller 2202. In some embodiments, multiple multi-lead memristors 102B may be part of a memristor network 114, as described above.

The at least one controller 2202 may function similarly to the processor 110. The at least one controller 2202 may be configured to perform (e.g., collectively perform if more than one controller) any or all of the operations disclosed throughout. The controller 2202 may be configured to run various software and/or firmware applications and/or computer code stored (e.g., maintained) in a non-transitory computer-readable medium and configured to execute various instructions or operations.

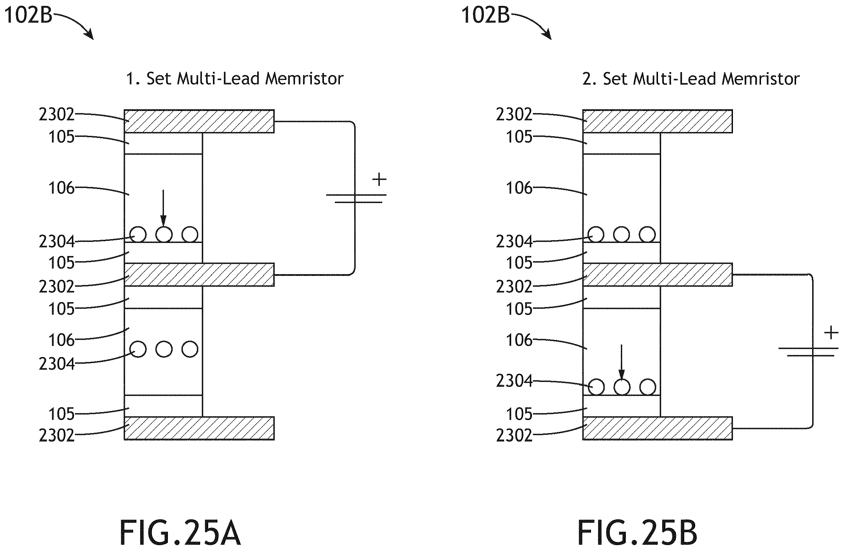

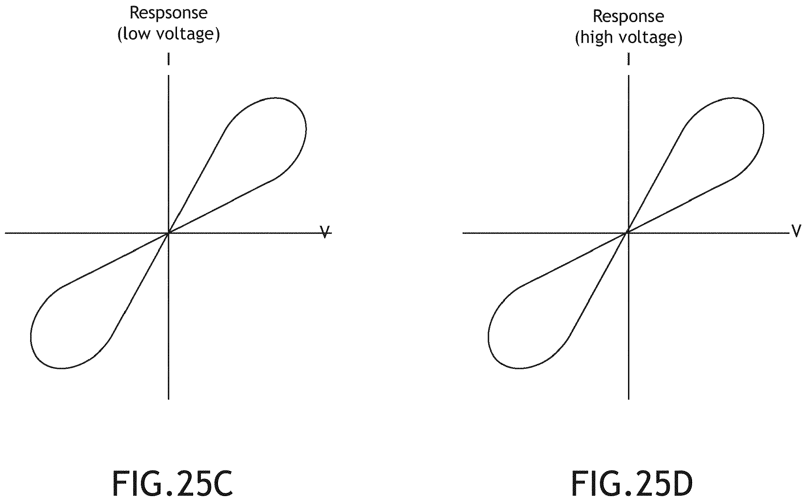

The controller 2202 is configured to configure (e.g., set) each multi-lead memristor 102B. For example, the controller is configured to set oxygen vacancies of the multi-lead memristor 102B, such as more fully described with respect to FIGS. 25A-27D below. The controller 2202 is configured to adjust an order of circuit activation within each multi-lead memristor 102B, for example, to alter an output response of each multi-lead memristor 102B according to a prescribed input application. The controller 2202 controls which lead (e.g., 2302) is driving oxygen vacancies in each multi-lead memristor 102B, thus allowing each multi-lead memristor 102B to be pre-set prior to subsequent readings; this allows each multi-lead memristor 102B to be reconfigured or to have multiple baseline configuration states related to an initial activation scheme.

For example, each multi-lead memristor 102B may function as at least one of a predefined or reconfigurable logic structure. In some embodiments, each multi-lead memristor 102B may function as a trimmer capacitor (e.g., a custom low stack trimmer capacitor). In some embodiments, each multi-lead memristor 102B may be configured to optimize and/or modify at least one analog circuit. In some embodiments, each multi-lead memristor 102B may be configured to allow trimming adjustments on electrical signals that use a resistive component. Some embodiments may allow for a size reduction when applied with thin film vapor deposition technology. Some embodiments may allow for a significant reduction in quantity of supporting electrical discrete parts. Some embodiments may eliminate and/or consolidate discrete components.

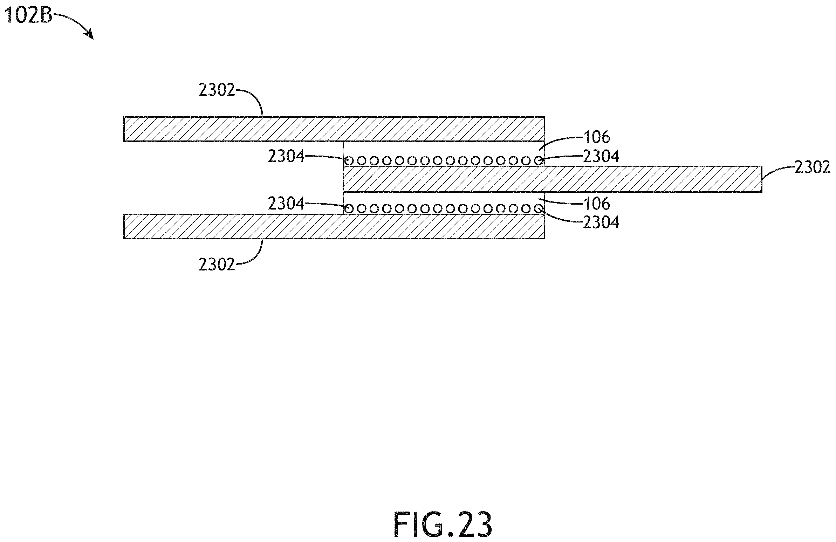

Referring now to FIG. 23, an exemplary embodiment of a multi-lead memristor 102B according to the inventive concepts disclosed herein is depicted.

The multi-lead memristor 102B may include at least three (e.g., three, as shown in FIG. 23) leads 2302 (e.g., terminals 104), at least two (e.g., two, as shown in FIG. 23) memristor materials 106 with each memristor material 106 including oxygen vacancies 2304.

The multi-lead memristor 102B may include a first lead 2302, a second lead 2302, and third lead 2302, wherein the second lead 2302 is positioned between the first lead 2302 and the third lead 2302. The multi-lead memristor 102B may include at least one first memristor material 106 positioned between the first lead 2302 and the second lead 2302. The multi-lead memristor 102B may include at least one second memristor material 106 positioned between the second lead 2302 and the third lead 2302. For example, the at least one first memristor material 106 may be a first memristor material 106, the at least one second memristor material 106 may be a second memristor material 106, and the first memristor material 106 may be a same or different material from the second memristor material 106.

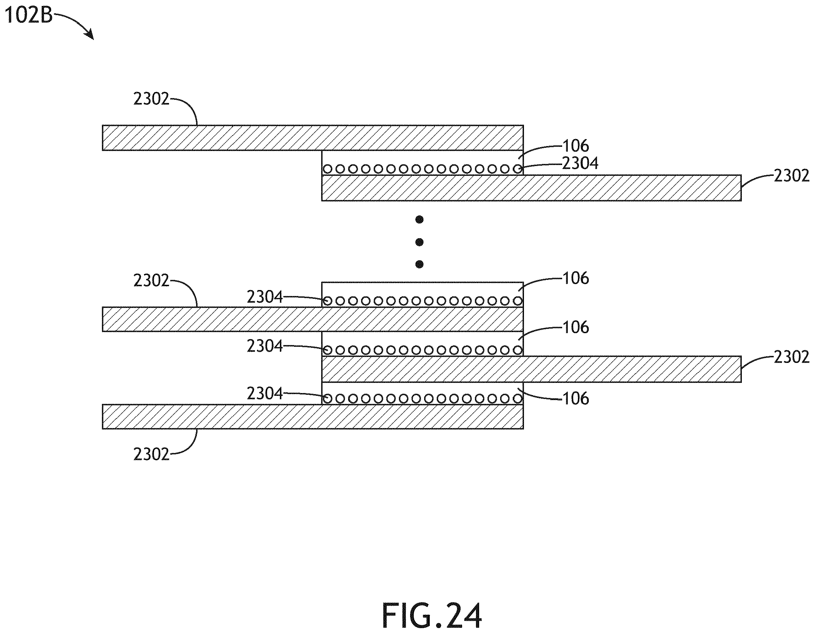

Referring now to FIG. 24, an exemplary embodiment of a multi-lead memristor 102B according to the inventive concepts disclosed herein is depicted. The multi-lead memristor 102B of FIG. 24 may include elements similar to and function similarly to the multi-lead memristor 102B of FIG. 23, except that the multi-lead memristor 102B of FIG. 24 may include more than three (e.g., four, five, ... , ten, etc.) leads 2302 and more than two (e.g., three, four, ... , nine, etc.) memristor materials 106.

Referring now to FIGS. 25A-D, an exemplary embodiment of the controller 2202 exemplarily setting oxygen vacancies 2304 of a multi-lead memristor 102B according to the inventive concepts disclosed herein is depicted.

As shown in FIG. 25A, the controller 2202 is configured to: use a direct current (DC) field applied to the first lead 2302 and the second lead 2302 to set oxygen vacancies 2304 of the at least one first memristor material 106 toward (e.g., fully toward) the second lead 2302. As shown in FIGS. 25B, the controller 2202 is configured to: use a DC field applied to the second lead 2302 and the third lead 2302 to set oxygen vacancies 2304 of the at least one second memristor material 106 toward (e.g., fully toward) the third lead 2302. The oxygen vacancies 2304 of the at least one first memristor material 106 may be in phase with the oxygen vacancies 2304 of the at least one second memristor material 106. As shown in FIGS. 25C-D, the multi-lead memristor 102B alternating current (AC) response is similar to a memristor 102 having a single memristor material 106 as because the oxygen vacancies 2304 are in phase.

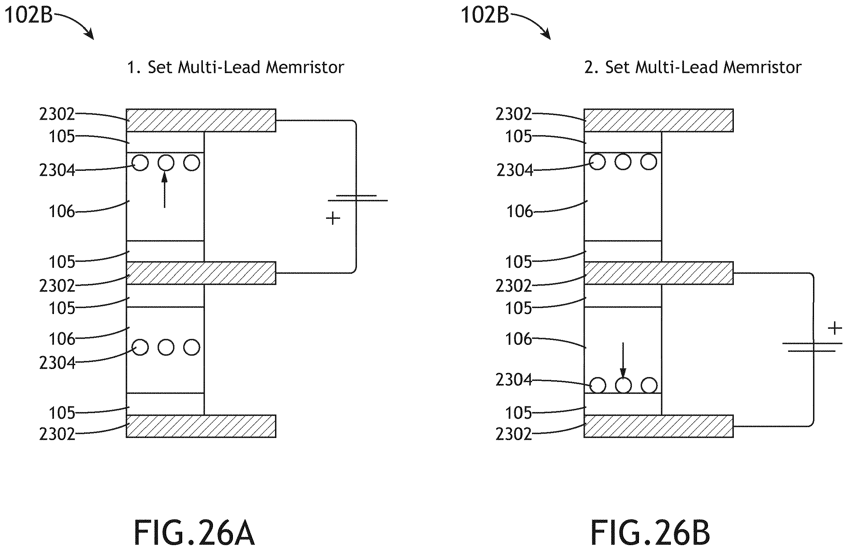

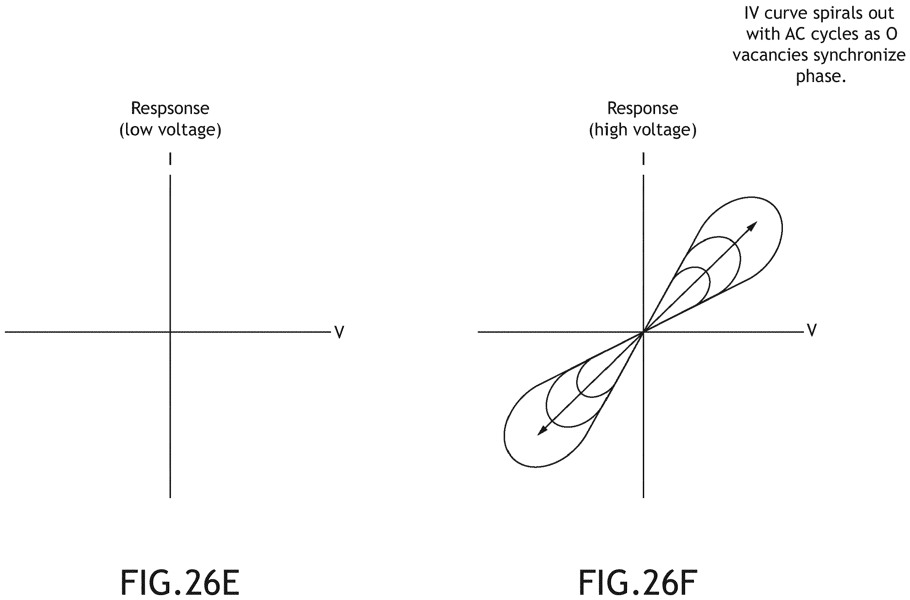

Referring now to FIGS. 26A-F, exemplary embodiments of the controller 2202 exemplarily setting oxygen vacancies 2304 of a multi-lead memristor 102B according to the inventive concepts disclosed herein are depicted.

In one embodiment, as shown in FIG. 26A, the controller 2202 is configured to: use a direct current (DC) field applied to the first lead 2302 and the second lead 2302 to set oxygen vacancies 2304 of the at least one first memristor material 106 toward (e.g., fully toward) the first lead 2302. As shown in FIG. 26B, the controller 2202 is configured to: use a DC field applied to the second lead 2302 and the third lead 2302 to set oxygen vacancies 2304 of the at least one second memristor material 106 toward (e.g., fully toward) the third lead 2302. The oxygen vacancies 2304 of the at least one first memristor material 106 may be out of phase with the oxygen vacancies 2304 of the at least one second memristor material 106. As shown in FIGS. 26E-F, because the oxygen vacancies 2304 are out of phase with each other, the low voltage IV curve may either show an open or high resistance response depending on the circuit and memristor 102B construction. With a higher voltage alternating side, oxygen vacancies 2304 may be brought back into phase in an AC or DC field.

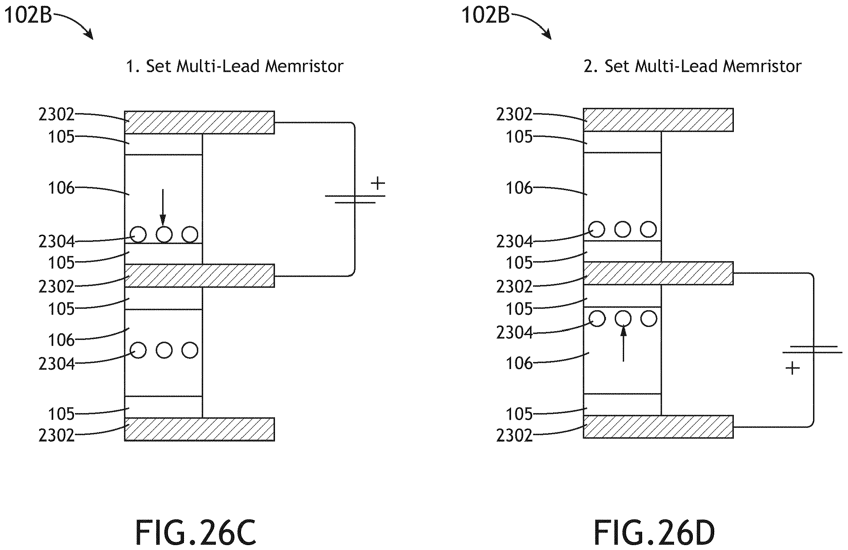

In another embodiment, as shown in FIG. 26C, the controller 2202 is configured to: use a direct current (DC) field applied to the first lead 2302 and the second lead 2302 to set oxygen vacancies 2304 of the at least one first memristor material 106 toward (e.g., fully toward) the second lead 2302. As shown in FIG. 26D, the controller 2202 is configured to: use a DC field applied to the second lead 2302 and the third lead 2302 to set oxygen vacancies 2304 of the at least one second memristor material 106 toward (e.g., fully toward) the second lead 2302. The oxygen vacancies 2304 of the at least one first memristor material 106 may be out of phase with the oxygen vacancies 2304 of the at least one second memristor material 106. As shown in FIGS. 26E-F, because the oxygen vacancies 2304 are out of phase with each other, the low voltage IV curve may either show an open or high resistance response depending on the circuit and memristor 102B construction. With a higher voltage alternating side, oxygen vacancies 2304 may be brought back into phase in an AC or DC field.

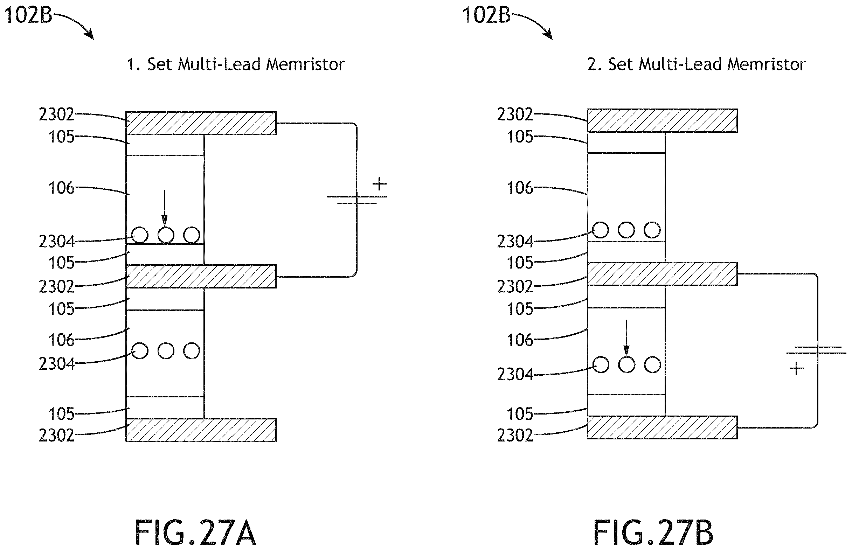

Referring now to FIGS. 27A-D, an exemplary embodiment of the controller 2202 exemplarily setting oxygen vacancies 2304 of a multi-lead memristor 102B according to the inventive concepts disclosed herein is depicted.

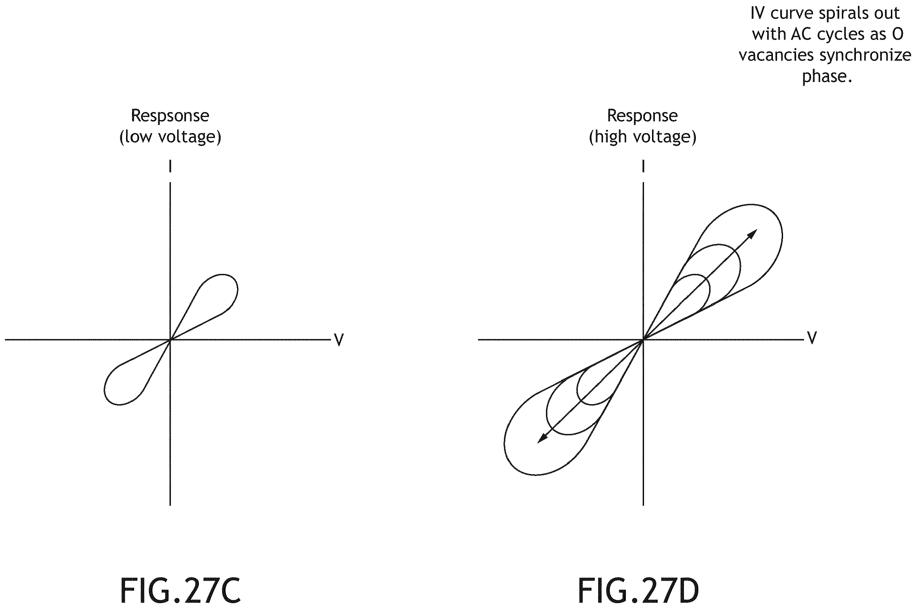

As shown in FIG. 27A, the controller 2202 is configured to: use a direct current (DC) field applied to the first lead 2302 and the second lead 2302 to set oxygen vacancies 2304 of the at least one first memristor material 106 fully toward one of the first lead 2302 or the second lead 2302. As shown in FIGS. 27B, the controller 2202 is configured to: use a DC field applied to the second lead 2302 and the third lead 2302 to set oxygen vacancies 2304 of the at least one second memristor material 106 in between (a) fully toward the second lead 2302 and (b) fully toward the third lead 2302. The oxygen vacancies 2304 of the at least one first memristor material 106 may be out of phase with the oxygen vacancies 2304 of the at least one second memristor material 106. As shown in FIGS. 27C-D, because the oxygen vacancies 2304 are out of phase with each other, the low voltage IV curve may look like memristor 102 with a smaller memristance response than either the first memristor material 106 or the second memristor material 106 taken alone. This type of multi-lead memristor 106B setting may be analogous to starting the multi-lead memristor 106B in a condition intermediate to a starting response and ending response of the high voltage response shown in FIG. 27D, where the IV curve spirals out with AC cycles as oxygen vacancies synchronize phase.

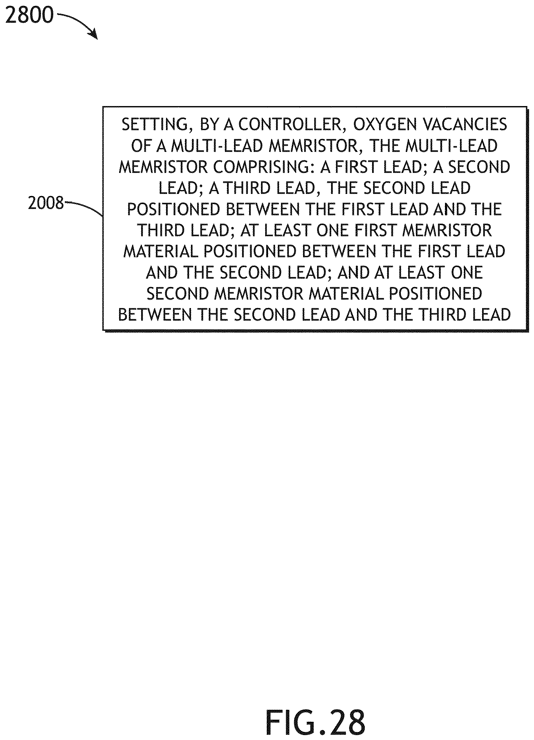

Referring now to FIG. 28, an exemplary embodiment of a method 2800 according to the inventive concepts disclosed herein may include one or more of the following steps. Additionally, for example, some embodiments may include performing one more instances of the method 2800 iteratively, concurrently, and/or sequentially. Additionally, for example, at least some of the steps of the method 2800 may be performed in parallel and/or concurrently. Additionally, in some embodiments, at least some of the steps of the method 2800 may be performed non-sequentially. Additionally, in some embodiments, at least some of the steps of the method 2800 may be performed in sub-steps of providing various components.

A step 2802 may include setting, by a controller, oxygen vacancies of a multi-lead memristor, the multi-lead memristor comprising: a first lead; a second lead; a third lead, the second lead positioned between the first lead and the third lead; at least one first memristor material positioned between the first lead and the second lead; and at least one second memristor material positioned between the second lead and the third lead.

Further, the method 2800 may include any of the operations disclosed throughout.

As will be appreciated from the above, embodiments of the inventive concepts disclosed herein may be directed to a method and a system including at least one device (e.g., at least one memristor) having at least one memristor material.

As used throughout and as would be appreciated by those skilled in the art, "at least one non-transitory computer-readable medium" may refer to as at least one non-transitory computer-readable medium (e.g., at least one memory device (e.g., a non-volatile memory device); e.g., at least one memristor; e.g., at least one computer-readable medium implemented as hardware; e.g., at least one non-transitory processor-readable medium, at least one memory (e.g., at least one nonvolatile memory, at least one volatile memory, or a combination thereof; e.g., at least one random-access memory, at least one flash memory, at least one read-only memory (ROM) (e.g., at least one electrically erasable programmable read-only memory (EEPROM)), at least one on-processor memory (e.g., at least one on-processor cache, at least one on-processor buffer, at least one on-processor flash memory, at least one on-processor EEPROM, or a combination thereof), or a combination thereof), at least one storage device (e.g., at least one hard-disk drive, at least one tape drive, at least one solid-state drive, at least one flash drive, at least one readable and/or writable disk of at least one optical drive configured to read from and/or write to the at least one readable and/or writable disk, or a combination thereof), or a combination thereof).

As used throughout, "at least one" means one or a plurality of; for example, "at least one" may comprise one, two, three, ..., one hundred, or more. Similarly, as used throughout, "one or more" means one or a plurality of; for example, "one or more" may comprise one, two, three, ..., one hundred, or more. Further, as used throughout, "zero or more" means zero, one, or a plurality of; for example, "zero or more" may comprise zero, one, two, three, ..., one hundred, or more.

In the present disclosure, the methods, operations, and/or functionality disclosed may be implemented as sets of instructions or software readable by a device. Further, it is understood that the specific order or hierarchy of steps in the methods, operations, and/or functionality disclosed are examples of exemplary approaches. Based upon design preferences, it is understood that the specific order or hierarchy of steps in the methods, operations, and/or functionality can be rearranged while remaining within the scope of the inventive concepts disclosed herein. The accompanying claims may present elements of the various steps in a sample order, and are not necessarily meant to be limited to the specific order or hierarchy presented.

It is to be understood that embodiments of the methods according to the inventive concepts disclosed herein may include one or more of the steps described herein. Further, such steps may be carried out in any desired order and two or more of the steps may be carried out simultaneously with one another. Two or more of the steps disclosed herein may be combined in a single step, and in some embodiments, one or more of the steps may be carried out as two or more sub-steps. Further, other steps or sub-steps may be carried in addition to, or as substitutes to one or more of the steps disclosed herein.

From the above description, it is clear that the inventive concepts disclosed herein are well adapted to carry out the objects and to attain the advantages mentioned herein as well as those inherent in the inventive concepts disclosed herein. While presently preferred embodiments of the inventive concepts disclosed herein have been described for purposes of this disclosure, it will be understood that numerous changes may be made which will readily suggest themselves to those skilled in the art and which are accomplished within the broad scope and coverage of the inventive concepts defined by the claims.

## Claims

1. A system, comprising:
a multi-lead memristor, comprising:
a first lead (2302);
a second lead (2302);
a third lead (2302), the second lead positioned between the first lead (2302) and the third lead;
at least one first memristor material (106-1) positioned between the first lead and the second lead; and
at least one second memristor material (106-2) positioned between the second lead and the third lead, and further comprising a controller (2202), wherein the controller is further configured to use a direct current field applied to the first lead and the second lead to set oxygen vacancies (2304) of the at least one first memristor material toward the second lead; and use a direct current field applied to the second lead and the third lead to set oxygen vacancies of the at least one second memristor material toward the third lead, and **characterized in that** the oxygen vacancies of the at least one first memristor material are controlled to be in phase with the oxygen vacancies of the at least one second memristor material.

2. The system of claim 1, wherein the at least one first memristor material is a first memristor material, wherein the at least one second memristor material is a second memristor material, wherein the first memristor material is a same or different material from the second memristor material.

3. The system of claim 1 or 2, wherein the multi-lead memristor has more than three leads and more than two memristor materials.

4. The system of claim 1, wherein the multi-lead memristor is configured to function is at least one of a predefined or reconfigurable logic structure.

5. The system of claim 1, wherein the controller is further configured to use a direct current field applied to the first lead and the second lead to set oxygen vacancies of the at least one first memristor material toward the first lead; and use a direct current field applied to the second lead and the third lead to set oxygen vacancies of the at least one second memristor material toward the third lead, wherein the oxygen vacancies of the at least one first memristor material are out of phase with the oxygen vacancies of the at least one second memristor material.

6. The system of claim 1, wherein the controller is further configured to use a direct current field applied to the first lead and the second lead to set oxygen vacancies of the at least one first memristor material toward the second lead; and use a direct w current field applied to the second lead and the third lead to set oxygen vacancies of the at least one second memristor material toward the second lead, wherein the oxygen vacancies of the at least one first memristor material are out of phase with the oxygen vacancies of the at least one second memristor material.

7. The system of claim 1, wherein the controller is further configured to use a direct current field applied to the first lead and the second lead to set oxygen vacancies of the at least one first memristor material fully toward one of the first lead and the second lead; and use a direct current field applied to the second lead and the third lead to set oxygen vacancies of the at least one second memristor material in between (a) fully toward the second lead and (b) fully toward the third lead.

8. The system of any preceding claim, wherein the multi-lead memristor is configured to function as a trimmer capacitor.

9. The system of any preceding claim, wherein the multi-lead memristor is configured to modify at least one analog circuit.

10. The system of any preceding claim, wherein the multi-lead memristor is configured to allow trimming adjustments on electrical signals that use a resistive component.

11. A method (2800), **characterized by** comprising:
setting, by a controller (2202), oxygen vacancies of a multi-lead memristor, the multi-lead memristor comprising: a first lead (2302), a second lead (2302), and a third lead (2302), the second lead positioned between the first lead and the third lead; at least one first memristor material positioned between the first lead and the second lead; and at least one second memristor material positioned between the second lead and the third lead, wherein the controller is further configured to use a direct current field applied to the first lead and the second lead to set oxygen vacancies of the at least one first memristor material toward the second lead; and use a direct current field applied to the second lead and the third lead to set oxygen vacancies of the at least one second memristor material toward the third lead, and **characterized in that** the oxygen vacancies of the at least one first memristor material are controlled to be in phase with the oxygen vacancies of the at least one second memristor material.

## Patentansprüche

1. System, umfassend:
einen Mehrleiter-Memristor, umfassend:
einen ersten Leiter (2302);
einen zweiten Leiter (2302);
einen dritten Leiter (2302), wobei der zweite Leiter zwischen dem ersten Leiter (2302) und dem dritten Leiter positioniert ist;
mindestens ein erstes Memristormaterial (106-1), das zwischen dem ersten Leiter und dem zweiten Leiter positioniert ist; und mindestens ein zweites Memristormaterial (106-2), das zwischen dem zweiten Leiter und dem dritten Leiter positioniert ist, und das ferner einen Controller (2202) umfasst, wobei der Controller ferner dazu konfiguriert ist, ein an den ersten Leiter und den zweiten Leiter angelegtes Gleichstromfeld zu verwenden, um Sauerstoffleerstellen (2304) des mindestens einen ersten Memristormaterials zu dem zweiten Leiter hin zu setzen; und ein an den zweiten Leiter und den dritten Leiter angelegtes Gleichstromfeld zu verwenden, um Sauerstoffleerstellen des mindestens einen zweiten Memristormaterials zu dem dritten Leiter hin zu setzen, und **dadurch gekennzeichnet, dass** die Sauerstoffleerstellen des mindestens einen ersten Memristormaterials so gesteuert werden, dass sie in Phase mit den Sauerstoffleerstellen des mindestens einen zweiten Memristormaterials sind.

2. System nach Anspruch 1, wobei das mindestens eine erste Memristormaterial ein erstes Memristormaterial ist, wobei das mindestens eine zweite Memristormaterial ein zweites Memristormaterial ist, wobei das erste Memristormaterial von demselben oder einem anderen Material als das zweite Memristormaterial ist.

3. System nach Anspruch 1 oder 2, wobei der Mehrleiter-Memristor mehr als drei Leiter und mehr als zwei Memristormaterialien aufweist.

4. System nach Anspruch 1, wobei der Mehrleiter-Memristor dazu konfiguriert ist, in mindestens einer von einer vordefinierten oder einer rekonfigurierbaren Logikstruktur zu funktionieren.

5. System nach Anspruch 1, wobei der Controller ferner dazu konfiguriert ist, ein an den ersten Leiter und den zweiten Leiter angelegtes Gleichstromfeld zu verwenden, um Sauerstoffleerstellen des mindestens einen ersten Memristormaterials zu dem ersten Leiter hin zu setzen; und ein an den zweiten Leiter und den dritten Leiter angelegtes Gleichstromfeld zu verwenden, um Sauerstoffleerstellen des mindestens einen zweiten Memristormaterials zu dem dritten Leiter hin zu setzen, wobei die Sauerstoffleerstellen des mindestens einen ersten Memristormaterials zu den Sauerstoffleerstellen des mindestens einen zweiten Memristormaterials phasenverschoben sind.

6. System nach Anspruch 1, wobei der Controller ferner dazu konfiguriert ist, ein an den ersten Leiter und den zweiten Leiter angelegtes Gleichstromfeld zu verwenden, um Sauerstoffleerstellen des mindestens einen ersten Memristormaterials zu dem zweiten Leiter hin zu setzen; und ein an den zweiten Leiter und den dritten Leiter angelegtes Gleichstromfeld zu verwenden, um Sauerstoffleerstellen des mindestens einen zweiten Memristormaterials zu dem zweiten Leiter hin zu setzen, wobei die Sauerstoffleerstellen des mindestens einen ersten Memristormaterials zu den Sauerstoffleerstellen des mindestens einen zweiten Memristormaterials phasenverschoben sind.

7. System nach Anspruch 1, wobei der Controller ferner dazu konfiguriert ist, ein an den ersten Leiter und den zweiten Leiter angelegtes Gleichstromfeld zu verwenden, um Sauerstoffleerstellen des mindestens einen ersten Memristormaterials vollständig zu einem von dem ersten Leiter und dem zweiten Leiter zu setzen; und ein an den zweiten Leiter und den dritten Leiter angelegtes Gleichstromfeld zu verwenden, um Sauerstoffleerstellen des mindestens einen zweiten Memristormaterials dazwischen (a) vollständig zu dem zweiten Leiter hin und (b) vollständig zu dem dritten Leiter hin zu setzen.

8. System nach einem der vorhergehenden Ansprüche, wobei der Mehrleiter-Memristor dazu konfiguriert ist, als Trimmerkondensator zu funktionieren.

9. System nach einem der vorhergehenden Ansprüche, wobei der Mehrleiter-Memristor dazu konfiguriert ist, mindestens eine analoge Schaltung zu modifizieren.

10. System nach einem der vorhergehenden Ansprüche, wobei der Mehrleiter-Memristor dazu konfiguriert ist, Trimmeinstellungen an elektrischen Signalen zu ermöglichen, die eine Widerstandskomponente verwenden.

11. Verfahren (2800), **dadurch gekennzeichnet, dass** es umfasst: Setzen von Sauerstoffleerstellen eines Mehrleiter-Memristors durch einen Controller (2202), wobei der Mehrleiter-Memristor umfasst: einen ersten Leiter (2302), einen zweiten Leiter (2302) und einen dritten Leiter (2302), wobei der zweite Leiter zwischen dem ersten Leiter und dem dritten Leiter positioniert ist; mindestens ein erstes Memristormaterial, das zwischen dem ersten Leiter und dem zweiten Leiter positioniert ist; und mindestens ein zweites Memristormaterial, das zwischen dem zweiten Leiter und dem dritten Leiter positioniert ist, wobei der Controller ferner dazu konfiguriert ist, ein an den ersten Leiter und den zweiten Leiter angelegtes Gleichstromfeld zu verwenden, um Sauerstoffleerstellen des mindestens einen ersten Memristormaterials zu dem zweiten Leiter hin zu setzen; und ein an den zweiten Leiter und den dritten Leiter angelegtes Gleichstromfeld zu verwenden, um Sauerstoffleerstellen des mindestens einen zweiten Memristormaterials zu dem dritten Leiter hin zu setzen, und **dadurch gekennzeichnet, dass** die Sauerstoffleerstellen des mindestens einen ersten Memristormaterials so gesteuert werden, dass sie in Phase mit den Sauerstoffleerstellen des mindestens einen zweiten Memristormaterials sind.

## Revendications

1. Système, comprenant :
une memristance multi-conducteurs, comprenant :
un premier conducteur (2302) ;
un deuxième conducteur (2302) ;
un troisième conducteur (2302), le deuxième conducteur étant positionné entre le premier conducteur (2302) et le troisième conducteur ;
au moins un premier matériau de memristance (106-1) positionné entre le premier conducteur et le deuxième conducteur ; et
au moins un second matériau de memristance (106-2) positionné entre le deuxième conducteur et le troisième conducteur, et comprenant également un dispositif de commande (2202), dans lequel le dispositif de commande est également configuré pour utiliser un champ de courant continu appliqué au premier conducteur et au deuxième conducteur pour régler des lacunes d'oxygène (2304) de l'au moins un premier matériau de memristance vers le deuxième conducteur ; et utiliser un champ de courant continu appliqué au deuxième conducteur et au troisième conducteur pour régler des lacunes d'oxygène de l'au moins un second matériau de memristance vers le troisième conducteur, et **caractérisé en ce que** les lacunes d'oxygène de l'au moins un premier matériau de memristance sont commandées pour être en phase avec les lacunes d'oxygène de l'au moins un second matériau de memristance.

2. Système selon la revendication 1, dans lequel l'au moins un premier matériau de memristance est un premier matériau de memristance, dans lequel l'au moins un second matériau de memristance est un second matériau de memristance, dans lequel le premier matériau de memristance est un matériau identique ou différent du second matériau de memristance.

3. Système selon la revendication 1 ou 2, dans lequel la memristance multi-conducteurs comporte plus de trois conducteurs et plus de deux matériaux de memristance.

4. Système selon la revendication 1, dans lequel la memristance multi-conducteurs est configurée pour fonctionner dans au moins une structure logique prédéfinie ou reconfigurable.

5. Système selon la revendication 1, dans lequel le dispositif de commande est également configuré pour utiliser un champ de courant continu appliqué au premier conducteur et au deuxième conducteur pour régler des lacunes d'oxygène de l'au moins un premier matériau de memristance vers le premier conducteur ; et utiliser un champ de courant continu appliqué au deuxième conducteur et au troisième conducteur pour régler des lacunes d'oxygène de l'au moins un second matériau de memristance vers le troisième conducteur, dans lequel les lacunes d'oxygène de l'au moins un premier matériau de memristance sont déphasées par rapport aux lacunes d'oxygène de l'au moins un second matériau de memristance.

6. Système selon la revendication 1, dans lequel le dispositif de commande est également configuré pour utiliser un champ de courant continu appliqué au premier conducteur et au deuxième conducteur pour régler des lacunes d'oxygène de l'au moins un premier matériau de memristance vers le deuxième conducteur ; et utiliser un champ de courant continu appliqué au deuxième conducteur et au troisième conducteur pour régler des lacunes d'oxygène de l'au moins un second matériau de memristance vers le deuxième conducteur, dans lequel les lacunes d'oxygène de l'au moins un premier matériau de memristance sont déphasées par rapport aux lacunes d'oxygène de l'au moins un second matériau de memristance.

7. Système selon la revendication 1, dans lequel le dispositif de commande est également configuré pour utiliser un champ de courant continu appliqué au premier conducteur et au deuxième conducteur pour régler des lacunes d'oxygène de l'au moins un premier matériau de memristance complètement vers l'un du premier conducteur et du deuxième conducteur ; et utiliser un champ de courant continu appliqué au deuxième conducteur et au troisième conducteur pour régler des lacunes d'oxygène de l'au moins un second matériau de memristance entre (a) complètement vers le deuxième conducteur et (b) complètement vers le troisième conducteur.

8. Système selon une quelconque revendication précédente, dans lequel la memristance multi-conducteurs est configurée pour fonctionner comme un condensateur de réglage.

9. Système selon une quelconque revendication précédente, dans lequel la memristance multi-conducteurs est configurée pour modifier au moins un circuit analogique.

10. Système selon une quelconque revendication précédente, dans lequel la memristance multi-conducteurs est configurée pour permettre des ajustements de réglage sur des signaux électriques qui utilisent un composant résistif.

11. Procédé (2800), **caractérisé en ce qu'**il comprend :
le réglage, par un dispositif de commande (2202), de lacunes d'oxygène d'une memristance multi-conducteurs, la memristance multi-conducteurs comprenant : un premier conducteur (2302), un deuxième conducteur (2302) et un troisième conducteur (2302), le deuxième conducteur étant positionné entre le premier conducteur et le troisième conducteur ; au moins un premier matériau de memristance positionné entre le premier conducteur et le deuxième conducteur ; et au moins un deuxième matériau de memristance positionné entre le deuxième conducteur et le troisième conducteur, dans lequel le dispositif de commande est également configuré pour utiliser un champ de courant continu appliqué au premier conducteur et au deuxième conducteur pour régler des lacunes d'oxygène de l'au moins un premier matériau de memristance vers le deuxième conducteur ; et utiliser un champ de courant continu appliqué au deuxième conducteur et au troisième conducteur pour régler des lacunes d'oxygène de l'au moins un second matériau de memristance vers le troisième conducteur, et **caractérisé en ce que** les lacunes d'oxygène de l'au moins un premier matériau de memristance sont commandées pour être en phase avec les lacunes d'oxygène de l'au moins un second matériau de memristance.
